(19) Europäisches Patentamt

European Patent Office

Office européen des brevets

(11) **EP 2 401 224 B1**

## (12) FASCICULE DE BREVET EUROPEEN

(45) Date de publication et mention
de la délivrance du brevet:
**22.08.2012 Bulletin 2012/34**

(21) Numéro de dépôt: **10710083.6**

(22) Date de dépôt: **24.02.2010**

(51) Int Cl.:
**B81C 1/00** (2006.01)

(86) Numéro de dépôt international:
**PCT/FR2010/050319**

(87) Numéro de publication internationale:
**WO 2010/097548 (02.09.2010 Gazette 2010/35)**

(54) **Procédé de fabrication de microcanaux sur un support et support comprenant de tels microcanaux**

Verfahren zur Herstellung von Mikrokanälen auf einem Substrat und Substrat mit derartigen Mikrokanälen

Method for making microchannels on a substrate, and substrate including such microchannels

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **25.02.2009 FR 0951200**

(43) Date de publication de la demande:
**04.01.2012 Bulletin 2012/01**

(73) Titulaire: **Universite Des Sciences Et Technologies De Lille**
**59655 Villeneuve d'Ascq (FR)**

(72) Inventeurs:
- **ABBAS, Abdennour**
**F-59650 Villeneuve D'Ascq (FR)**
- **GUILLOCHON, Didier**
**F-59700 Marcq en Baroeul (FR)**
- **BOCQUET, Bertrand**
**F-59650 Villeneuve D'Ascq (FR)**
- **SUPIOT, Philippe**
**F-59370 Mons en Baroeul (FR)**

(74) Mandataire: **Balesta, Pierre**
**Cabinet Beau de Loménie**
**Immeuble Eurocentre (EURALILLE)**
**179 boulevard de Turin**
**F-59777 Lille (FR)**

(56) Documents cités:
**DE-A1- 10 320 297     US-A1- 2002 025 529
US-B1- 6 204 200**

- **MILLE V ET AL: "New technology for high throughput THz BioMEMS" ENGINEERING IN MEDICINE AND BIOLOGY SOCIETY, 2006. EMBS '06. 28TH ANNUAL INTERNATIONAL CONFERENCE OF THE IEEE, IEEE, PISCATAWAY, NJ, USA, 30 août 2006 (2006-08-30), pages 3505-3508, XP031236276 ISBN: 978-1-4244-0032-4**

**Description**

La présente invention a pour objet un procédé de fabrication de microcanaux sur un support, et un support comprenant de tels microcanaux. Elle trouve notamment son application à la fabrication de supports microstructurés destinés à être utilisés dans des systèmes microélectroniques, et/ou microfluidiques, et/ou micromécaniques.

De tels microcanaux sur un support structuré sont d'un grand intérêt dans trois domaines principaux : les circuits intégrés, dans lesquels on cherche à créer des volumes ou espaces remplis d'air dans les structures interconnectées en vue de réduire au maximum la constante diélectrique (« Kohl P A, Zhao Q, Patel K, Schmidt D, Allen S A B, Shick R, and Jayaraman S 1998 Air-Gaps for Electrical Interconnections Electrochem. Solid-State Lett., 1, 49-51 ») ; les investigations en mécanique des fluides à l'échelle du micron (« Zhao B, Moore J S, Beebe D J 2001 Surface-Directed Liquid Flow Inside Microchannels Science, 291, 1023-26 ») ; les dispositifs microfluidiques tels que les « bio-MEMS » ou « chemical-MEMS » (bio-Systèmes MicroElectroMécaniques ou Systèmes MicroElectroMécaniques chimiques), biocapteurs et « lab-on-chips » (« Delamarche E, Bernard A, Schmid H, Michel B, Biebuyck H Patterned 1997 Delivery of Immunoglobulins to Surfaces Using Microfluidic Networks Science, 276, 779-781 » et « Treizebré A and Bocquet B 2008 Nanometric metal wire as a guide for THz investigation of living cells Int. J. Nanotechnol. 05 Nos. 6/7/8 784-95 »).

On comprend donc qu'il y ait de nos jours un intérêt de plus en plus grand à la mise au point de méthodes rapides et peu couteuses pour la fabrication de tels microcanaux.

On connaît de nombreuses techniques pour la fabrication de circuits microfluidiques. Celles qui prédominent sont les techniques de gravure, les procédés de réplications basés essentiellement sur le moulage à base d'un matériau polymère, et l'utilisation d'un matériau sacrificiel.

Parmi les techniques de gravure, on connaît par exemple les techniques décrites dans « Boer M J d, Tjerkstra R W, Berenschot J W, Jansen H V, Burger G J, Gardeniers J G E, Elwenspoek M, and Van den Berg A 2000 Micromachining of Buried Micro Channels in Silicon IEEE J. MEMS, 9, 94-103 », et « Dwivedi V K , Gopal R and Ahmad S 2000 Fabrication of very smooth walls and bottoms of silicon microchannels for heat dissipation of semiconductor devices Microelectron. J. , 31, 405-410».

Parmi les procédés de réplications basés essentiellement sur le moulage à base d'un matériau polymère, on connaît les procédés décrits dans « Mcdonald J C And Whitesides G M 2002 Poly(dimethylsiloxane) as a material for fabricating microfluidic devices Acc. Chem. Res.,35, 491-499 » et « Chie R-D 2006 Micromolding of biochip devices designed with microchannels Sens. Actuators, A: Physical, 128, 238-247 ».

Parmi les techniques basées sur l'utilisation d'un matériau sacrificiel, on connaît la technique décrite dans « Peeni B A, Lee M L, Hawkins A R and Woolley A T 2006 Sacrificial layer microfluidic device fabrication methods Electrophoresis, 27, 4888-4895 »

Les principaux inconvénients à la fois des techniques de gravure et de moulage polymère, sont leur faible flexibilité pour une adaptation à différents matériaux pour la couche inférieure, la nécessité d'utiliser plusieurs masques photolithographiques ce qui multiplie les étapes couteuses en temps, et la nécessité d'utiliser des méthodes d'alignement et de liaison des différentes couches fabriquées.

Ces différentes étapes nécessitent en outre généralement des traitements thermiques ou chimiques pouvant conduire au désalignement d'une tranche par rapport à une autre. On citera, à titre d'exemple, « Chatterjee R, Fayolle M, Leduc P, Pozder S, Jones B, Acosta E, Charlet B, Enot T, Heitzmann M, Zussy M, Roman A, Louveau O, Maitrejean S, Louis D, Kernevez N, Sillon N, Passemard G, Po V, Mathew V, Garcia S, Sparks T, Huang Z 2007 Three dimensional chip stacking using a wafer-to-wafer intégration International Interconnect Technology Conference, IEEE, 4-6 June, pp 81-83 ».

La seule technique qui permet une fabrication simple et rapide de microcanaux sur un côté d'une tranche de silicium est la technique utilisant un matériau sacrificiel.

Selon cette technique, la fabrication d'un microcanal consiste dans le dépôt d'une couche sacrificielle et en la réalisation de motifs de formes souhaitées dans cette couche.

Un matériau structurant est alors déposé sur la couche sacrificielle présentant les motifs.

Après ouverture des accès pour gravure dans les parois du canal, le matériau sacrificiel est dissout chimiquement ou thermiquement, ou encore par gravure plasma, laissant ainsi la place à un canal fermé.

Selon la demande de brevet US 2002/025529 A1 on dépose une couche en poly(dimethylsiloxane) par dessus une structure sacrificielle. La couche est polymérisée en utilisant une source UV et un photo-initiateur. Après, la structure sacrificielle est retirée.

On utilise généralement différentes sortes de matériaux pour la couche sacrificielle, tels que des matériaux photosensibles, principalement des matériaux électroniques photorésistants, des matériaux thermiquement décomposables comme du polycarbonate, du polyoxyméthylène, du polynorbornène, du parylène, et des matériaux solubles dans l'eau comme des acides (poly) acryliques et des alcools polyvynyliques.

On citera par exemple les publications suivantes : « Walsh K, Norville J and Tai Y-C 2001 Photoresist as a sacrificial layer by dissolution in acetone The 14th IEEE International Conférence on Micro Electro Mechanical Systems, p114 - 117 », « Jayachandran J P, Reed H A, Zhen H, Rhodes L F, Henderson C L, Allen S A B, and Kohl P A, 2003 Air-Channel Fabrication for Microelectromechanical Systems via Sacrificial Photosensitive Polycarbonates IEEE J. MEMS, 12, 147-159 », « L S and Gleason K K 2001 Hot filament chemical vapor deposition of polyoxymethylene as a sacrificial layer for fabricating air gaps Electrochem. Solid-State Lett., 4, G81-G84 », « Bhusari D, Reed H A, Wedlake M, Padovani A M, Sue Ann Bidstrup Allen, and Kohl P A 2001 Fabrication of air-channel structures for microfluidic, microelectromechanical, and microelectronic applications IEEE J. MEMS, 10, 400-408 », « Wu X, Reed H A, Wang Y, Rhodes L F, Elce E, Ravikiran R, Shick R A, Henderson C L, Allen S A B, and Kohl P A 2003 Fabrication of Microchannels Using Polynorbornene Photosensitive Sacrificial Materials J. Electrochem. Soc., 150, H205-H213 », « Noha H-s, Choib Y, Wu C-f, Heskethaand P J, Allen M G 2003 Rapid, low-cost fabrication of parylene microchannels for microfluidic applications The 12th International Conference on Solid State Sensors, Actuators and Microsystems: Boston, June 8-12 » , « Linder V, Gates B D, Ryan D, Parviz B A, Whitesides G M 2005 Water-Soluble Sacrificial Layers for Surface Micromachining Small, 7, 730-6».

Concernant la couche de dépôt superficiel du matériau structurant, la technique la plus utilisée est le dépôt chimique en phase vapeur (CVD pour Chemical Vapor Deposition) de dioxyde de silicium ($SiO_2$), de nitrure de silicium ($SiN_x$), de carbure de silicium (SiC), ou de différents métaux tels que de l'aluminium (Al), du nickel (Ni) ou du titane (Ti).

Cependant, ces matériaux sont déposés à des températures élevées, généralement supérieures ou égales à 200 °C. Cela nécessite donc d'utiliser des matériaux présentant une stabilité thermique élevée ainsi qu'une température de transition vitreuse élevée. Cela implique également d'utiliser des couches d'adhésion.

De telles contraintes limitent considérablement le nombre de matériaux que l'on peut utiliser.

Par ailleurs, avec les techniques connues, on ne peut pas créer sur le même support, et au cours d'un unique processus de fabrication, des canaux dont la largeur varie de quelques micromètres à plusieurs centaines de micromètres.

En particulier, la création de microcanaux de grande largeur (plusieurs centaines de micromètres) peut engendrer un affaissement de la couche supérieure, réduisant la section de passage dans le canal, voire bouchant complètement ce canal, sauf à prévoir de renforcer ces canaux par des sortes de piliers.

A l'inverse, la création de microcanaux de faible largeur (quelques micromètres) nécessite absolument l'utilisation d'une couche sacrificielle

En outre, il est difficile d'obtenir des canaux avec une section de géométrie variée et contrôlée, en raison notamment de la difficulté à contrôler la façon dont se dépose la couche superficielle qui vient fermer les canaux.

La présente invention a donc pour objet d'apporter une solution aux problèmes précités, parmi d'autres problèmes.

A cet effet, l'objet de la présente invention concerne un procédé simple de fabrication de microcanaux au moins partiellement fermés (sur leur longueur) ou au moins partiellement recouverts, basé sur une technologie alternative appelée polymérisation plasma sur surface microstructurée (PPMS pour Plasma Polymerization on Micropatterned Surface).

Plus précisément, le procédé de l'invention est basé sur le dépôt par polymérisation plasma d'un matériau de revêtement supérieur à température ambiante.

Cette polymérisation plasma est du type dépôt chimique en phase vapeur assisté, éventuellement à distance, par plasma (PECVD pour Plasma-Enhanced Chemical Vapor Deposition, éventuellement RPECVD pour Remote Plasma-Enhanced Chemical Vapor Deposition).

Selon cette technique, un monomère organique et/ou organométallique est converti en un polymère réticulé, par l'intermédiaire d'une décomposition partielle activée par des espèces plasma énergétiques.

Ces processus sont accompagnés du dépôt consécutif de films polymères de faible épaisseur sur la couche inférieure.

Un des avantages principaux de cette polymérisation plasma selon l'invention est qu'elle se produit à température modérée, comparativement aux méthodes plasma conventionnelles.

Ceci permet d'utiliser un large panel de matériaux pour la couche sacrificielle ou la couche encapsulée.

Ces avantages proviennent du fait que le film ainsi déposé par cette polymérisation plasma spécifique présente une forte biocompatibilité, une bonne adhésion sur différents types de couche inférieure, et de très intéressantes propriétés de surface tant pour les flux en microfluidique que pour la fonctionnalisation.

Précisément, l'invention se rapporte ainsi, selon un premier aspect, à un procédé de fabrication d'au moins un microcanal fermé sur au moins une partie de sa longueur, sur un support, notamment en vue de créer un support de type microstructuré.

Par canal fermé sur au moins une partie de sa longueur, on entend canal au moins partiellement recouvert, ou encore un canal dont au moins une partie forme un tube (à section éventuellement variable).

Le procédé comprend une étape de réalisation d'au moins un ou d'au moins deux motifs à la surface d'une couche inférieure, et une étape de dépôt, par-dessus la couche inférieure et le motif ou les deux motifs, d'une couche en matériau polymère.

De façon caractéristique, l'étape de dépôt de la couche en matériau polymère comprend une étape de polymérisation, dans un réacteur de dépôt chimique en phase vapeur assisté, éventuellement à distance, par plasma (ou PECVD pour Plasma-Enhanced Chemical Vapor Deposition, éventuellement RPECVD pour Remote Plasma-Enhanced Chemical Vapor Deposition), d'un monomère organique ou organométallique.

Ce monomère comprend des fonctions siloxanes, de préférence du tétraméthyldisiloxane.

Cette étape de dépôt de la couche en matériau polymère est réalisée en sorte de créer, à la place du motif et après une étape de révélation par décomposition de ce motif, ou entre les deux motifs sans étape de révélation par décomposition de ces deux motifs, un canal fermé sur au moins une partie de sa longueur.

Il est ainsi possible, grâce à ce procédé, de créer un ou plusieurs canaux sur le support présentant des dimensions variées, en particulier des largeurs variant de quelques microns à plusieurs centaines de microns, et des géométries variées (section circulaire, rectangulaire).

Le procédé de croissance du matériau polymère structurant, en particulier dans le cas où le précurseur monomère est le ou comprend du tétraméthyldisiloxane (TMDS ou TMDSO), permet, en combinaison avec des motifs de géométrie et de tailles variées, l'obtention d'un large panel de canaux.

La couche en matériau polymère joue ainsi le rôle d'enveloppe fermant au moins partiellement les canaux, tout en modifiant la géométrie des motifs par le processus de croissance du matériau polymère, par exemple en faisant apparaître des excroissances générant des formes et dimensions variées pour les motifs, et donc pour les canaux.

Les bonnes qualités mécaniques du matériau formant la couche polymère structurante fermant les canaux participent également à la possibilité de former des canaux de dimensions et de géométrie variable, notamment en raison d'un bon module élastique (solidité, souplesse) en partie due à la présente du groupe Si-O-Si.

Plusieurs variantes de mise en oeuvre du procédé de l'invention sont présentées ci-après, qui peuvent être considérées seules ou en combinaison avec une ou plusieurs quelconques des autres variantes.

Le monomère utilisé lors de l'étape de dépôt de la couche en matériau polymère peut comprendre des fonctions siloxanes exemptes d'hydrogène labile, de préférence de l'hexaméthyldisiloxane.

L'étape de réalisation du motif ou des deux motifs peut comprendre une étape de dépôt sur la couche inférieure d'une couche photorésistante, et une étape de réalisation du motif ou des deux motifs dans cette couche photorésistante par photolithographie.

Le dépôt de la couche photorésistante peut être réalisé par exemple par tournette ou par polymérisation plasma.

Alternativement, l'étape de réalisation du motif ou des deux motifs peut comprendre une étape de gravure directement dans la couche inférieure.

Le motif ou les deux motifs correspondent alors à une ou des parties de la couche inférieure non gravées.

Le motif ou les deux motifs présentent de préférence une hauteur (H) comprise entre 1 et 30 $\mu$m, en

sorte de créer à la place dudit motif (2) ou entre lesdits deux motifs (2) un canal de hauteur (H) comprise entre 1 et 30 $\mu$m.

Le motif peut présenter une largeur (L) comprise entre 5 et 1000 $\mu$m, de préférence entre 100 et 1000 $\mu$m, en sorte de créer à la place du motif un canal de largeur (L) comprise entre 5 et 1000 $\mu$m, de préférence entre 100 et 1000 $\mu$m.

Dans le cas où l'on réalise deux motifs, ces deux motifs peuvent être espacés l'un de l'autre d'une distance (L) inférieure ou égale à 5 $\mu$m, de préférence inférieure ou égale à 4 $\mu$m, en sorte de créer entre ces deux motifs un canal de largeur (L) inférieure ou égale à 5 $\mu$m, de préférence inférieure ou égale à 4 $\mu$m.

L'invention se rapporte également, selon un deuxième aspect, à un procédé de fabrication d'au moins deux microcanaux fermés sur au moins une partie de leur longueur, sur un support, notamment en vue de créer un support de type microstructuré.

De façon caractéristique, le procédé comprend une étape de création d'un premier microcanal de largeur (L) inférieure ou égale à 5 $\mu$m, de préférence inférieure ou égale à 4 $\mu$m, tel qu'expliqué ci-dessus, et une étape de création d'un deuxième microcanal de largeur (L) comprise entre 5 et 1000 $\mu$m, de préférence entre 100 et 1000 $\mu$m, tel qu'expliqué ci-dessus.

De préférence, ce procédé comprend une unique étape de dépôt, par-dessus la couche inférieure et les motifs, d'une couche en matériau polymère.

Il est ainsi possible, avec le même procédé simple et peu coûteux, notamment avec une unique étape de réalisation de motif, une unique étape de dépôt de matériau structurant, et une unique étape de révélation par décomposition de certains motifs, de réaliser sur un même support plusieurs microcanaux dont la largeur varie de 1 à 1000 $\mu$m, c'est-à-dire de quelques microns à quelques centaines de microns.

L'invention se rapporte également, selon un troisième aspect, à un support, notamment de type microstructuré destiné par exemple à former tout ou partie d'un système microélectronique et/ou microfluidique et/ou micromécanique.

De façon caractéristique, le support comprend au moins un canal fabriqué par le procédé selon le premier aspect de l'invention, ou au moins deux canaux fabriqués par le procédé selon le deuxième aspect de l'invention.

D'autres caractéristiques et avantages de l'invention apparaîtront plus clairement et de manière complète à la lecture de la description ci-après des variantes préférées de mise en oeuvre du procédé et de réalisation du support, lesquelles sont données à titre d'exemples non limitatifs et en référence aux dessins annexés suivants :

- figure 1 : représente schématiquement plusieurs variantes du procédé de l'invention,
- figure 2 : représente schématiquement le principe du dépôt chimique en phase vapeur assisté à distance par plasma,

- figures 3a, 3b, 3c : représentent schématiquement des exemples de microcanaux obtenus par le procédé de l'invention,
- figure 4 : représente schématiquement un exemple de microcanal de grande largeur obtenu par le procédé de l'invention,
- figure 5 : représente schématiquement un exemple de MEMS fluidique.

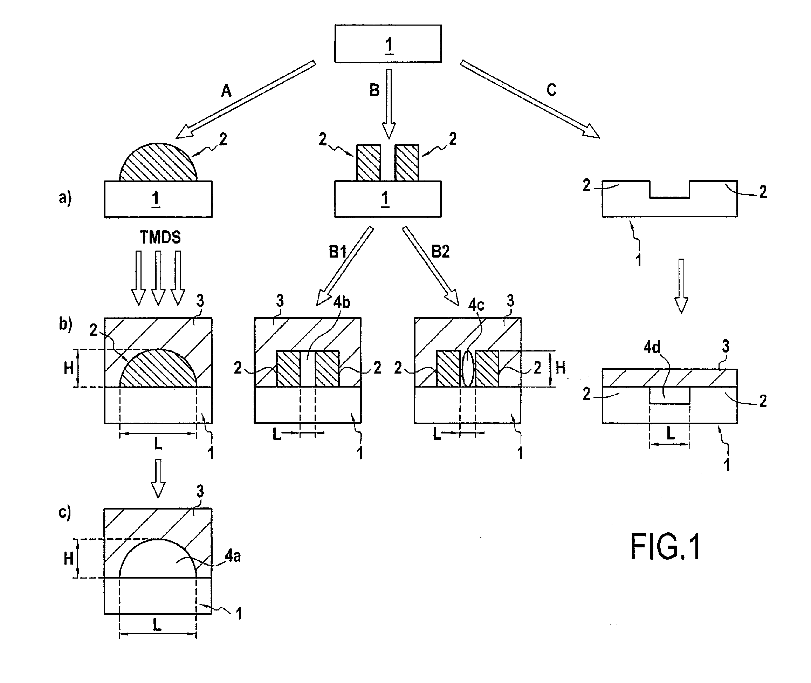

La figure 1 représente schématiquement plusieurs variantes du procédé de l'invention.

Précisément, une première variante A suit la branche A sur la figure 1, une deuxième variante suit la branche B sur cette figure 1, et une troisième variante suit la branche C sur cette figure 1.

La branche B se subdivise en une branche B1 et une branche B2, de sorte que la deuxième variante B se subdivise en une variante B1 et une variante B2.

Tout d'abord, quelles que soient les variantes, une étape (a) est mise en oeuvre pour la réalisation de motifs 2 sur une couche inférieure 1, par exemple une tranche de silicium 1.

La réalisation de ces motifs 2 peut être obtenue par une technique classique de photolithographie, en deux étapes. Tout d'abord, le matériau sacrificiel consistant en un matériau photorésistant positif est déposé sur la couche inférieure 1, par exemple un procédé dit de « spin-coating ». Les paramètres « spin » et viscosité de la solution polymère utilisée permettent de contrôler l'épaisseur de la couche déposée, ce qui détermine la hauteur H des motifs 2.

Le matériau déposé est ensuite nettoyé pour permettre l'évaporation du solvant utilisé. Puis le matériau est exposé à des rayons UV à travers un masque de haute résolution. Les zones non exposées aux UV sont dissoutes par immersion du support dans une solution basique, laissant apparaître la couche sacrificielle avec les motifs 2 sur la couche inférieure 1.

A titre d'exemple, les paramètres utilisés pour cette étape (a) de réalisation des motifs 2 par photolithographie peuvent être les suivants, pour une épaisseur de motifs 2 de l'ordre de 25 μm :

1/ première passe de « spin-coating » (par exemple avec résine AZ9260) :

- vitesse : 2000 tr/min
- accélération : 5000, 40 s
- stabilisation : 10 min
- cuisson : 100°C pendant 3 min
- réabsorption de l'eau : 15 min à température ambiante

2/ deuxième passe de « spin-coating » (par exemple avec résine AZ9260)

- vitesse : 2000 tr/min
- accélération : 5000, 40 s
- stabilisation : 10 min
- cuisson : 100°C pendant 3 min
- réabsorption de l'eau : 15 min à température ambiante

3/ Exposition aux UV : 365 nm pour une dose de 10 mJ.cm-2, pendant 45 secondes
4/ Développement : dissolution dans une solution de type AZ 351 b, pendant 90 secondes
5/ Cuisson finale : 100°C pendant 1 min.

Dans la variante correspondant à la branche A, on crée au moins un motif 2 dont la largeur L peut être de l'ordre de plusieurs centaines de microns, jusqu'à 1000 microns.

Cette largeur L sera par ailleurs supérieure ou égale à 5 microns (de préférence supérieure à 100 microns), car en dessous de cette valeur, on atteint la limite de la résolution de l'étape suivante (b) de dépôt du matériau structurant, qui est de l'ordre de 4 microns. En effet, en dessous de cette valeur, le dépôt ultérieur à l'étape (b) ne se fera pas uniformément autour du motif 2 et sur la couche inférieure 1, laissant un volume non recouvert le long des parois latérales du motif 2, et donc en final un canal de largeur non contrôlée par la largeur L du motif 2.

Dans les deux variantes correspondant aux deux branches B1 et B2, on crée au moins deux motifs espacés d'une largeur L inférieure ou égale à la résolution mentionnée ci-dessus (de l'ordre de 4 microns) dans la variante B1, ou supérieure à cette valeur de résolution mais de l'ordre de quelques microns (de l'ordre de 5 microns de préférence) dans la variante B2. En effet, pour cette variante B2, au-delà de quelques microns au-dessus de la valeur de résolution, l'étape ultérieure de dépôt (b) conduira à obstruer complètement l'espace entre les deux motifs 2, donc en final à l'impossibilité de créer un canal sans retrait ou révélation des motifs 2.

Dans la variante correspondant à la branche C, les deux motifs sont obtenus par gravure directement dans la couche inférieure 1. Comme pour la variante B se subdivisant en une variante B1 et une variante B2, la variante C peut être subdivisée en deux variantes, dont seule la première a été représentée en figure 1 pour simplifier.

Dans cette première variante représentée à la figure 1, concernant la branche C, la largeur L de la gravure est inférieure ou égale à la résolution mentionnée plus haut (de l'ordre de 4 microns). Dans l'autre variante non représentée à la figure 1, concernant cette branche C, la largeur L de la gravure est supérieure à cette valeur de résolution mais de l'ordre de quelques microns (de l'ordre de 5 microns de préférence). Dans cette variante C, le remplissage de la tranchée résultante par la résine sacrificielle utilisée dans les deux variantes A et B peut également être mis à profit pour assurer le maintien et/ou la mise en forme du polymère plasma pour la couverture du canal.

Précisément, l'étape (b) suivante consiste dans le dépôt de la couche supérieure 3 en matériau structurant, sur la surface du support, c'est-à-dire par-dessus les motifs 2 et la couche inférieure 1.

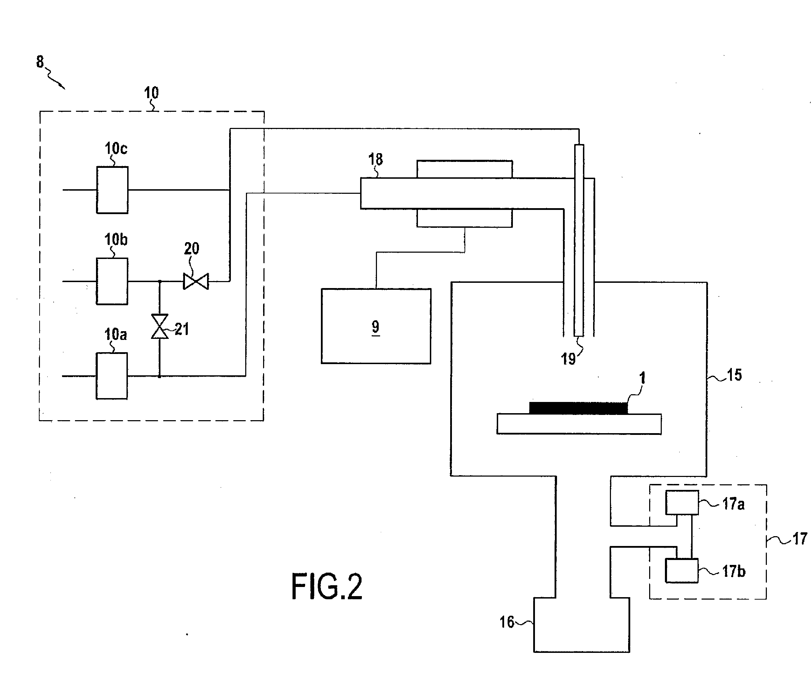

Cette étape est de type polymérisation plasma. Le support est introduit dans un réacteur (voir plus loin explications relatives à la figure 2).

Lors de cette étape (b), on utilise un précurseur monomère organique ou organométallique, pour synthétiser et déposer le film polymère, par une technique de dépôt chimique en phase vapeur assisté, éventuellement à distance, par plasma (PECVD, éventuellement RPECVD).

Le monomère ainsi polymérisé par polymérisation plasma constitue le matériau structurant 3 des microcanaux 4, 4a, 4b, 4c, 4d qui vont être créés (directement à l'étape (b) pour les deux variantes B1 et B2, et la variante C, ou à l'étape (c) pour la variante A).

Ce dépôt est réalisé à la température ambiante, ce qui est un avantage important.

Ci-dessous, à titre d'exemple, sont donnés les paramètres de l'étape (b) de dépôt de la couche (3) de matériau structurant (cette étape (b) étant décrite plus loin plus en détail en référence à la figure 2) :

- pression de base : 28 Pa,
- pression opérationnelle : 560 Pa,
- puissance : 200 W,
- gaz plasmagène : $N_2$ (1.8 litres standards / min),
- gaz vecteur : $O_2$ (25 $cm^3$ standards / min),
- pré-traitement : plasma $N_2$ pendant 4 min, suivi de plasma $N_{2/}$ $O_2$ pendant 3 min,
- dépôt : plasma TMDSO (5 $cm^3$ standards / min).

La dernière étape, telle que représentée à la figure 1, ne concerne que la variante A. Lors de cette étape (c), la couche sacrificielle ayant servi à la réalisation du motif 2 est retirée. On parle de révélation par décomposition du motif 2.

Cette révélation est obtenue par immersion de l'ensemble (support comprenant la couche inférieure 1, le motif 2 et la couche structurante 3) dans une solution de développement, par exemple de type AZ351B, préparée avec de l'eau dé-ionisée.

Le motif 2, en matériau sacrificiel photorésistant, se décompose en produits volatiles et solubles, laissant un volume 4a qui s'étend entre la couche inférieure 1 et la couche polymère structurante 3, qui forme un canal 4a.

Il est à noter que dans l'exemple représenter à la figure 1, variante A, le canal 4a obtenu à l'issu de l'étape (c) présente une forme arrondie en partie supérieure, en raison de la forme arrondie en partie supérieure du motif 2 utilisé à l'étape (b).

Toutefois, et de préférence, on obtient un canal 4a de géométrie sensiblement identique avec un motif tronqué en partie supérieure par rapport à celui représenté sur la figure, c'est-à-dire avec des parois latérales arrondies mais une paroi supérieure sensiblement plane.

En effet, le procédé lithographique utilisé à l'étape (a) pour la réalisation du motif 2 permet d'obtenir l'arrondi au niveau des parois latérales, mais pas (ou difficilement) au niveau de la paroi supérieure.

Dans ce cas, c'est le processus de dépôt à l'étape (c) qui, en raison d'une contrainte accrue au niveau de la base des motifs, engendre une polymérisation en arrondi en partie supérieure, au-dessus de la paroi supérieure sensiblement plane du motif 2. On obtient donc ainsi un canal 4a à l'issu de l'étape (c) arrondi tel que représenté en figure 1, à partir d'un motif 2 à paroi supérieure sensiblement plane.

L'étape (c) de révélation par décomposition du motif 2 n'est pas mise en oeuvre dans les deux variantes B1 et B2, ni dans la variante C.

En effet, en raison de la taille de l'espace séparant les deux motifs 2 dans les variantes B1 et B2 et dans la variante C, de l'ordre de quelques microns, et tel qu'expliqué plus haut, la polymérisation du monomère lors de l'étape (b) ne vient pas combler cet espace. Autrement dit, il n'y a quasiment pas ou peu de dépôt de couche polymère structurante 3 dans cette espace.

Précisément, dans la variante B1 comme dans la variante C, les deux motifs 2 sont séparés d'une distance L inférieure ou égale à la résolution de dépôt de la couche polymère structurante 3 (de l'ordre de 4 microns), de sorte que la polymérisation ne se produit quasiment pas dans l'espace séparant les deux motifs 2. Cela conduit à la formation d'un canal 4b (pour la variante B1) ou 4d (pour la variante C) entre les deux motifs, à section sensiblement rectangulaire.

Par ailleurs, dans la variante B2, les deux motifs 2 sont séparés d'une distance L supérieure à la résolution de dépôt de la couche polymère structurante 3 mais qui reste de l'ordre de quelques microns, de préférence inférieure ou égale à 5 microns, de sorte que la polymérisation se produit en partie le long des parois verticales des motifs 2 en vis-à-vis, dans l'espace séparant ces deux motifs 2, avec une accumulation de polymère en partie haute et basse de ces parois verticales et très peu, voire pas du tout, de polymère sur la partie centrale de ces parois verticales et sur la couche inférieure 1 au centre de l'espace séparant les deux motifs 2. Cela conduit à la formation d'un canal 4c entre les deux motifs, à section sensiblement circulaire.

Dans la variante B2, si l'on espace les deux motifs 2 au-delà de quelques microns, déjà au-delà de 5 microns, la polymérisation tend à remplir complètement l'espace entre les deux motifs 2. On se retrouve alors dans la situation de la variante A et la nécessité d'une étape (c) de révélation qui va permettre le retrait des motifs 2 et laisser place à deux canaux à la place de ces deux motifs 2.

Comme déjà évoqué plus haut, une autre variante de la variante C est possible, correspondant à la variante B2 en terme d'espacement des motifs et de géométrie du canal obtenu, mais avec gravure dans la couche inférieure 1 pour la formation des motifs 2.

Dans toutes ces variantes, les canaux (ou microcanaux) 4a, 4b, 4c, 4d sont optiquement transparents, notamment en raison des propriétés du monomère précurseur utilisé pour le dépôt de la couche structurante 3.

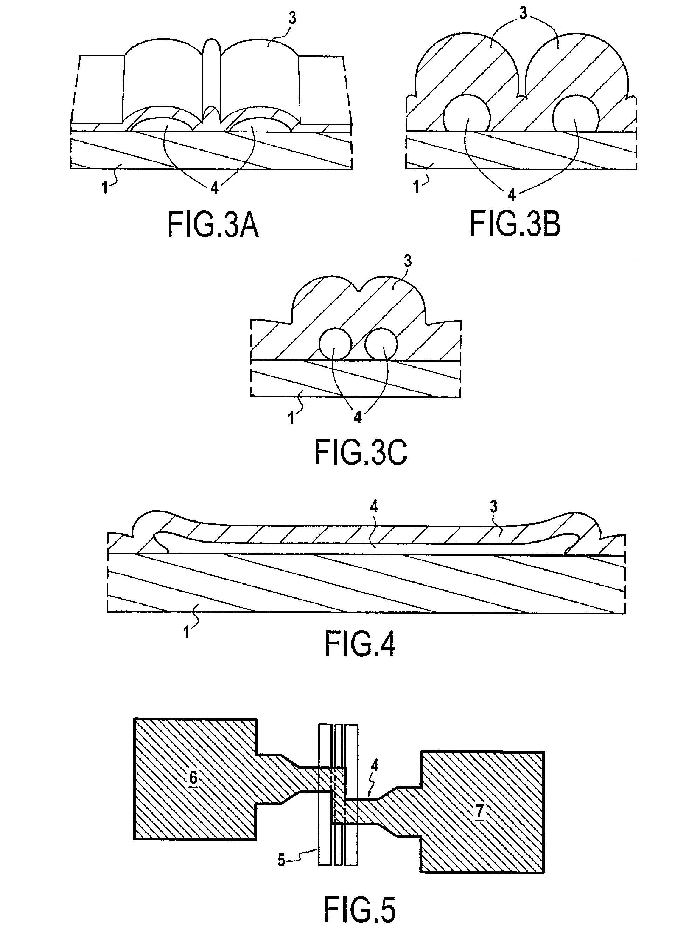

Ainsi, on retrouve aux figures 3a, 3b et 3c des exemples typiques de canaux 4 formés par le procédé de l'invention, avec le dépôt de la couche polymère structurante 3 tel qu'expliqué plus haut, sur une couche inférieure silicium 1.

A la figure 3a, les canaux 4 sont beaucoup plus larges que hauts, alors qu'aux figures 3b et 3c, les canaux 4 sont sensiblement aussi larges que hauts avec une section partiellement circulaire (figure 3b) voire quasicirculaire (figure 3c).

Les structures obtenues peuvent être avantageusement rincées dans de l'eau dé-ionisée, puis subir un séchage $CO_2$ supercritique, pour éviter l'effet de collage engendré par les forces capillaires.

L'exemple représenté à la figure 4 illustre le résultat du procédé de l'invention pour la formation d'un canal 4 de plusieurs centaines de microns, très large par rapport à sa hauteur.

On constate que malgré la grande largeur du canal 4 et l'absence de piliers de soutien, il ne se produit pas d'affaissement de la couche polymère structurante 3 sur la couche inférieure 1. On peut simplement observer des sortes de bourrelets le long des parois latérales, provenant du phénomène de « casquette » lors de la polymérisation le long des arêtes supérieures des motifs 2.

L'étape (b) de polymérisation plasma du monomère utilisé pour former et déposer la couche polymère structurante 3 est expliquée plus en détail, en référence à la figure 2.

Les couches inférieures recevant les microcircuits reposent sur la platine d'un réacteur de dépôt chimique en phase vapeur assisté, éventuellement à distance (ou en différé), par plasma (PECVD, éventuellement RPECVD), éventuellement à l'aide d'un système de fixation adéquat.

La platine est ensuite introduite dans le réacteur de dépôt RPECVD, puis ce dernier est refermé.

Il est possible de régler le positionnement de la platine à l'aide d'un système de positionnement contrôlé à l'aide d'un système adapté.

La figure 2 représente donc de manière schématique un exemple de structure du réacteur de dépôt RPECVD mis en oeuvre. Le réacteur 8 comprend quatre zones : le générateur de plasma 9, le système d'injection des gaz 10, la chambre de dépôt 15, l'auxiliaire de pompage 16.

La ou les pompes 16 permettent de mettre l'enceinte 15 du réacteur 8 sous basse pression. De cette façon, les équilibres liquidevapeur des espèces chimiques utilisées au cours du procédé sont déplacés en faveur de la vaporisation des composés. La pression au sein du réacteur 8 peut être suivie et contrôlée en permanence à l'aide de sonde de mesure 17 (par exemple des sondes capacitive 17a et Pirani 17b).

Le système d'injection des gaz 10 alimente une conduite d'alimentation 18 en verre ou en silice fondue et une buse coaxiale 19 en matériau du même type. La conduite principale 18 est alimentée en azote à l'aide d'un régulateur de débit massique 10a. La buse coaxiale 19 est alimentée en oxygène ou en composés chimiques vaporisés nécessaires au procédé de croissance ou en un mélange de ces gaz à l'aide des régulateurs de débit massiques 10b et 10c respectivement.

Deux vannes 20 et 21 peuvent être utilisées pour la gestion du pré-traitement $N_2$-$O_2$.

Ainsi, pour ce pré-traitement (avant traitement par plasma), on prévoit d'ouvrir la vanne de mélange 21 et de fermer la vanne 20, de sorte d'injecter le mélange $N_2$-$O_2$ issu des régulateurs de débit massiques 10a et 10b dans la conduite 18.

Pour le traitement plasma sous $O_2$, il suffit ensuite de fermer la vanne de mélange 21 et d'ouvrir la vanne 20.

La source du plasma est un applicateur coaxial excité par un générateur micro-ondes, mais peut aussi s'appuyer sur toute source de plasma produisant des atomes d'azote en quantité nécessaire, moyennant éventuellement une adaptation du domaine de pression de travail. Une section de la conduite 18 est soumise au rayonnement électromagnétique en amont de la chambre de dépôt 15.

La buse 19 et la conduite 18 débouchent sur la chambre de dépôt 15 où a été placée la couche inférieure 1 à traiter.

La couche inférieure 1 préalablement préparée hors réacteur, éventuellement exposée à la seule postdécharge du plasma d'azote pour un ultime nettoyage, est ensuite exposée au mélange réactionnel permettant le dépôt de films polymériques à sa surface. Ceci se fait sans remise à l'air des échantillons prétraités.

Les débits d'oxygène et de précurseur de polymère sont réglés. Ce mélange gazeux est injecté via la buse coaxiale 19 située en amont de la chambre de dépôt 15. Cette injection peut se traduire par l'apparition d'un cône d'une luminosité différente de celle du gaz en post-décharge en raison des réactions avec les vecteurs énergétiques de la post-décharge.

Dans un mode préféré de réalisation, le précurseur de polymère employé est le tétraméthyldisiloxane (TMDSO), une molécule présentant un pont oxyde entre deux atomes de silicium. Ces atomes portent de plus chacun deux groupements méthyle et un atome d'hydrogène.

Lors de son exposition à l'azote excité de la post-décharge, le TMDSO est fragmenté en diverses espèces radicalaires extrêmement réactives. Celles-ci réagissent entre elles, avec l'oxygène et l'azote radicalaire présents dans le mélange gazeux et avec le matériau de la couche inférieure 1 entre autres. Les vitesses de dépôt typiques des films sont de l'ordre de 10 nm/s.

Plus généralement, on peut utiliser des monomères de la même famille, selon deux approches :

- monomères comprenant des fonctions siloxanes de structures similaires ou différentes (molécules cycliques, cages) tel que du tétraméthylcyclotétrasiloxane (TMCTSO), pouvant présenter un plus grand nombre de pont oxygène et un ou plusieurs atomes d'hydrogène labiles liés avec le silicium,
- monomères comprenant des fonctions siloxanes présentant des caractéristiques identiques à celles précédemment mentionnées mais exemptes d'hydrogène labile, tel que de l'hexaméthyledisiloxane (HMDSO)

Dans cette deuxième approche, le mode préféré inclura une modification du procédé, soit par l'usage d'additifs à l'azote utilisé pour la génération du plasma dans cette même configuration (une ligne de gaz doit alors être rajoutée à cet effet dans le système d'injection de gaz 10 dans l'exemple de structure du réacteur représenté à la figure 2), soit par un déplacement du point d'injection du mélange polymérisant vers une position plus amont, ou encore en plaçant conjointement le point d'injection dudit mélange et la couche inférieure dans le milieu ionisé généré par le plasma (mode PECVD ou RPECVD).

Dans ce dernier cas, le gaz $N_2$ peut être substitué, par exemple, par de l'argon ou de l'hélium et le plasma généré à faible puissance électromagnétique moyenne (pulsé ou non) afin de préserver le squelette du précurseur de dépôt. On recrée ainsi des conditions énergétiques et physico-chimiques se rapprochant de celles de la RPECVD décrites dans le mode préféré de réalisation. Un aménagement des géométries du réacteur est dans ce cas nécessaire afin de permettre l'immersion de la couche inférieure 1.

On notera que cette dernière configuration est également compatible avec l'utilisation de précurseur siloxane à hydrogène labile.

La phase de dépôt du polymère s'effectue par accroche moléculaire de fragments organosiliciés de différentes tailles. D'autres fragments, recombinés ou non, viennent ensuite s'accrocher à ces points.

A partir de ces ancrages, un réseau plus ou moins réticulé de filaments moléculaires constitués principalement de chaînes à base de $-(CH_3)_2SiO-$ dans l'exemple préféré de réalisation va croître.

L'enchevêtrement de ces filaments ainsi que leur réticulation mènent à l'obtention de dépôts dont la morphologie est celle de films polymères amorphes ou faiblement structurés. L'épaisseur des films obtenus n'est fonction que du temps d'exposition au spray de $O_2$ et de TMDSO, tous les autres paramètres restant identiques par ailleurs.

A titre d'exemple, on peut utiliser un support réalisé selon le procédé de l'invention pour fabriquer un système de type BioMEMS (BioMicroElectro Mechanical System).

Il est ainsi possible d'intégrer des circuits microfluidiques directement sur une couche inférieure supportant des composants électriques ou électromagnétiques.

Précisément, dans l'exemple représenté à la figure 5, il est question d'une couche inférieure supportant un guide d'onde coplanaire 5 sur lequel on peut directement déposer un motif de géométrie appropriée pour former, après déroulement des étapes précitées du procédé de l'invention, un canal 4.

Dans cet exemple, les deux extrémités du canal 4 sont élargies pour passer d'une largeur de quelques microns jusqu'à quelques centaines de microns, à une largeur de 1 mm, et déboucher dans deux réservoirs 6 et 7 dont le but est de favoriser l'accès fluidique.

Ces réservoirs peuvent être obtenus par masquage durant le dépôt de la couche structurante par polymérisation plasma, puis en les utilisant en tant que trous de gravure de la couche sacrificielle.

Il est ainsi possible avec le procédé de l'invention, de former des microcanaux au moins partiellement fermés (ou recouverts) sur leur longueur, grâce notamment aux propriétés spécifiques de la couche polymère structurante et aux procédés RPECVD de dépôt de cette couche.

En particulier, le dépôt à partir d'un précurseur monomère de type organique ou organométallique, tel que le TMDS (ou TMDSO), présente une bonne résistance mécanique, permettant de réaliser des canaux larges sans affaissement pendant ou après la fabrication.

Le procédé permet d'obtenir une grande variété de dimensions et de géométries de canaux.

Ceci est rendu possible, non seulement grâce aux propriétés physiques du monomère utilisé, mais aussi grâce au mode spécifique de polymérisation du monomère, en particulier le long des arêtes des motifs formant la structure sur la couche inférieure.

En plus de l'avantage lié à son faible coût et lié à son adaptation à une production de masse, le procédé de l'invention présente l'avantage de permettre de créer des canaux aux propriétés physiques et chimiques intéressantes, telle que la transparence dans les longueurs d'onde visibles, la stabilité chimique par rapport aux solvants utilisés dans les procédés de lithographie, la relative faible permittivité ($\approx 4$) avec peu de pertes dans le domaine des ondes millimétriques et dans le domaine des fréquences de l'ordre du teraHertz.

Ceci est tout particulièrement important pour la conception de MEMS basés sur des guides d'onde électromagnétiques.

En outre, contrairement à la plupart des polymères, le polymère issu de la polymérisation plasma d'un précurseur monomère tel que le TMDSO n'est pas autofluorescent, ce qui permet de mettre en oeuvre des techniques de détection par fluorescence.

Cette polymérisation plasma permet d'obtenir une bonne adhésion sur une large gamme de couches inférieures, et d'éviter ainsi d'utiliser une couche d'adhésion supplémentaire.

En outre, la résolution de dépôt (distance entre deux motifs en dessous de laquelle le dépôt du film polymère ne se produit pas entre les deux motifs) a été estimée, pour le procédé de l'invention, approximativement à 4 μm.

Cela permet donc de créer des canaux de très faible largeur {< 4 μm), sans avoir à utiliser un matériau sacrificiel et une étape de révélation par décomposition du matériau sacrificiel.

En ce qui concerne l'exemple de bioMEMS représenté à la figure 5, le demandeur a pu mettre au point un microcanal 4 de 2 mm de long et 20 μm de haut, avec un volume total de 23 nL.

Les deux réservoirs 6 et 7 servent d'accès pour la solution de gravure, de ports d'entrée et de sortie, et de fournisseur de tension de surface permettant le remplissage du canal 4 par les forces de capillarités.

Les forces de capillarité sont largement dominantes dans les systèmes microfluidiques, en raison du ratio surface sur volume qui est élevé.

La tension de surface fournit la pression suffisante pour faire avancer le liquide dans le canal 4. Le flux du liquide à l'intérieur de canaux de taille de l'ordre du micromètre est essentiellement laminaire (nombre de Reynolds < 500 pour le canal 4 dans notre exemple).

Malgré le caractère hydrophobe de la couche de polymère structurante utilisée, il n'est pas nécessaire de traiter la surface pour pouvoir remplir le canal, à l'inverse de canaux formés avec une couche de polymères hydrophobes, telle que le PDMS qui requiert un traitement préalable d'hydrophilisation pour permettre l'action capillaire positive.

Ceci provient de trois facteurs principaux : la pression capillaire produite par le liquide à l'entrée du canal au niveau d'un réservoir qui permet l'entrée du liquide dans le canal ; les constrictions périodiques présentes au niveau des parois internes des canaux, qui favorisent les effets de capillarité et le déplacement des solutions aqueuses le long de la surface du canal ; les parois internes des canaux sont non mouillables.

En effet, la pression capillaire peut être donnée par la formule

$$p = 2\delta\left(\frac{1}{h} + \frac{1}{w}\right) \quad (1)$$

où w est la largeur du canal, h sa hauteur, et δ est sa tension de surface ( δ(H$_2$O) = 7,36.10$^{-2}$ N.m$^{-1}$ à 20 °C).

Dans la mesure où la largeur du réservoir est bien plus importante que son épaisseur (sa hauteur), (1) peut être simplifiée en p = 2δ/h.

La différence de pression à l'entrée du microcanal utilisé dans l'exemple présenté ci-dessus relativement à la figure 5, est alors p = 8,1. 10$^7$ Pa.

Cette pression draine le liquide avec une vélocité initiale de 4.4 cm.s$^{-1}$.

La vitesse de remplissage est réduite à la fin à 2,2 mm.s$^{-1}$, en raison de la perte de pression et des effets de la viscosité.

La vitesse de remplissage est ainsi déterminée par la géométrie du canal, son énergie de surface et les propriétés du liquide.

Les constrictions périodiques le long des parois internes du canal présentent, dans l'exemple relatif à la figure 5, une largeur et une hauteur de 1 à 2 μm

Comme indiquées plus haut, ces constrictions favorisent les effets de capillarité et le déplacement des solutions aqueuses le long de la surface du canal

Ceci peut également être très utile pour la fonctionnalisation du canal, dans la mesure où ces constrictions engendrées réduisent la vitesse du flux à proximité de la surface, ce qui augmente la durée de résidence (c'est-à-dire la durée au cours de laquelle le liquide reste dans le canal) et donc les interactions de surface, ce qui finalement favorise l'adsorption et la condensation des molécules.

Enfin, les parois internes du microcanal sont effectivement non mouillables, seule la partie silicium étant mouillable avec des angles de contact statiques θ (Si) = 58° ± 3° et θ(TMDS polymérisé) = 95° ± 3°.

Les énergies de surface totale sont : 41,7 mJ.m$^{-2}$ (composante dispersive $\gamma_d$= 24,1 mJ.m$^{-2}$ ; composante polaire $\gamma_p$= 17,7 mJ.m$^{-2}$) et 22,3 mJ.m$^{-2}$ ($\gamma_d$ = 20,4 mJ.m$^{-2}$ , $\gamma_p$ = 1,9 mJ.m$^{-2}$) pour les surfaces respectives hydrophiles et hydrophobes.

Les parois internes en TMDS polymérisé génèrent une pression positive agissant contre le remplissage, alors que la force de la tension de surface provenant de la surface silicium hydrophile en partie basse réduit l'effet du TMDS polymérisé et aide le liquide à s'écouler à l'intérieur du canal.

On peut également citer d'autres facteurs qui affectent le glissement du liquide, tels que la rugosité de la surface et la réduction de la largeur du canal, qui agissent comme des valves passives.

Ainsi, le procédé de l'invention permet de créer facilement des microcanaux de formes et dimensions variées, avec des caractéristiques de surface variées.

En outre, le procédé permet l'intégration directe et rapide de circuits fluidiques sur des capteurs variés tels que des microélectrodes et des guides d'onde.

La mise en oeuvre de la polymérisation plasma permet d'éviter les étapes de liaison (ou d'adhésion) dans le protocole de fabrication.

Cette mise en oeuvre est réalisée à température ambiante.

Cette mise en oeuvre permet l'utilisation d'une large gamme de matériaux organiques ou organométalliques pour le dépôt de la couche polymère structurante, qui présentent des propriétés intéressantes de biocompatibilité et qui sont facilement fonctionnalisables.

Différents matériaux peuvent être utilisés pour la couche inférieure, sans utilisation de couche de liaison.

Le procédé peut être facilement mis en oeuvre à l'échelle industrielle.

En outre, le procédé permet la fabrication à la fois de canaux de grande largeur (plusieurs centaines de microns, supérieure à 700 μm) sans piliers de soutien, et des canaux de faible largeur sans utilisation d'une technique sacrificielle (quelques micromètres, inférieure à 5 μm).

La présente description et en particulier les exemples présentés ci-dessus sont donnés à titre d'exemple et ne sont donc pas limitatifs de l'invention.

## Revendications

1. Procédé de fabrication d'au moins un microcanal (4, 4a, 4b, 4c, 4d) fermé sur au moins une partie de sa longueur, sur un support, notamment en vue de créer un support de type microstructuré, comprenant une étape (a) de réalisation d'au moins un ou d'au moins deux motifs (2) à la surface d'une couche inférieure (1), une étape (b) de dépôt, par-dessus ladite couche inférieure (1) et le ou lesdits deux motifs (2), d'une couche (3) en matériau polymère, **caractérisé en ce que** l'étape (b) de dépôt de ladite couche (3) en matériau polymère comprend une étape de polymérisation, dans un réacteur (5) de dépôt chimique en phase vapeur assisté, éventuellement à distance, par plasma, d'un monomère organique ou organométallique comprenant des fonctions siloxanes, de préférence du tétraméthyldisiloxane, en sorte de créer, à la place dudit motif (2) et après une étape (c) de révélation par décomposition de ce dit motif (2), ou entre lesdits deux motifs (2) sans étape (c) de révélation par décomposition de ces dits deux motifs (2), un canal (4, 4a, 4b, 4c, 4d) fermé sur au moins une partie de sa longueur.

2. Procédé selon la revendication 1, **caractérisé en ce que** le monomère utilisé lors de l'étape (b) de dépôt de la couche (3) en matériau polymère, comprend des fonctions siloxanes exemptes d'hydrogène labile, de préférence de l'hexaméthyldisiloxane.

3. Procédé selon l'une quelconque des revendications 1 et 2, **caractérisé en ce que** l'étape (a) de réalisation du ou des deux motifs (2) comprend une étape de dépôt sur la couche inférieure (1) d'une couche photorésistante, par exemple par tournette ou par polymérisation plasma, et une étape de réalisation du ou desdits deux motifs (2) dans cette dite couche photorésistante par photolithographie,

4. Procédé selon l'une quelconque des revendications 1 et 2, **caractérisé en ce que** l'étape (a) de réalisation du ou des deux motifs (2) comprend une étape de gravure directement dans la couche inférieure (1), le ou lesdits deux motifs (2) correspondant alors à une ou des parties de ladite couche inférieure (1) non gravées.

5. Procédé selon l'une quelconque des revendications 1 à 4, **caractérisé en ce que** le ou les deux motifs (2) présentent une hauteur (H) comprise entre 1 et 30 μm, en sorte de créer à la place dudit motif (2) ou entre lesdits deux motifs (2) un canal (4, 4a, 4b, 4c, 4d) de hauteur (H) comprise entre 1 et 30 μm.

6. Procédé selon l'une quelconque des revendications 1 à 5, **caractérisé en ce que** le motif (2) présente une largeur (L) comprise entre 5 et 1000 μm, de préférence entre 100 et 1000 μm, en sorte de créer à la place dudit motif (2) un canal (4, 4a) de largeur (L) comprise entre 5 et 1000 μm, de préférence entre 100 et 1000 μm.

7. Procédé selon l'une quelconque des revendications 1 à 5, comprenant une étape (a) de réalisation de deux motifs (2) à la surface de la couche inférieure (1), **caractérisé en ce que** lesdits deux motifs (2) sont espacés l'un de l'autre d'une distance (L) inférieure ou égale à 5 μm, de préférence inférieure ou égale à 4 μm, en sorte de créer entre lesdits deux motifs (2) un canal (4, 4b, 4c, 4d) de largeur (L) inférieure ou égale à 5 μm, de préférence inférieure ou égale à 4 μm,

8. Procédé de fabrication d'au moins deux microcanaux (4, 4a, 4b, 4c, 4d) fermés sur au moins une partie de leur longueur, sur un support, notamment en vue de créer un support de type microstructuré, **caractérisé en ce qu'**il comprend une étape de création d'un premier canal (4, 4a) par le procédé selon la revendication 6 et une étape de création d'un deuxième canal (4, 4b, 4c, 4d) par le procédé selon la revendication 7.

9. Procédé selon la revendication 8, **caractérisé en ce qu'**il comprend une unique étape (b) de dépôt, par-dessus la couche inférieure (1) et les motifs (2), d'une couche (3) en matériau polymère.

10. Support, notamment de type microstructuré destiné par exemple à former tout ou partie d'un système microélectronique et/ou microfluidique et/ou micromécanique, **caractérisé en ce qu'**il comprend au moins un canal (4, 4a, 4b, 4c, 4d) fabriqué par le procédé selon l'une quelconque des revendications 1 à 7, et/ou au moins deux canaux (4, 4a, 4b, 4c, 4d) fabriqués par le procédé selon l'une quelconque des revendications 8 et 9, dont au moins un canal a des parois formées par une couche inférieure (1), une couche (3) en matériau polymère et lesdits deux motifs (2) ou une couche inférieure (1) et une couche (3) en matériau polymère.

## Claims

1. A process for fabricating at least one microchannel (4, 4a, 4b, 4c, 4d), closed over at least part of its length, on a substrate, especially for the purpose of creating a microstructured substrate, comprising a step (a) of producing at least one or at least two patterns (2) on the surface of a bottom layer (1), a step (b) of depositing, on top of said bottom layer (1) and said one or two patterns (2), a layer (3) of polymer material,
   **characterized in that** step (b) of depositing said layer (3) of polymer material comprises a step of polymerizing an organic or organometallic monomer containing siloxane functional groups, preferably tetramethyldisiloxane, in a plasma-enhanced, optionally remote plasma-enhanced, chemical vapor deposition reactor (5) so as to create, in place of said pattern (2) and after a development step (c) by decomposing of this said pattern (2), or between said two patterns (2) without a development step (c) by decomposing these said two patterns (2), a channel (4, 4a, 4b, 4c, 4d) closed over at least part of its length.

2. A process according to claim 1, **characterized in that** the monomer used in the step (b) of depositing the layer (3) of polymer material contains siloxane functional groups having no labile hydrogen, preferably hexamethyldisiloxane.

3. A process according to claim 1 or claim 2, **characterized in that** step (a) of producing the one or two patterns (2) comprises a step of depositing a photoresist layer on the bottom layer (1), for example by spin coating or by plasma polymerization, and a step of producing the one or two patterns (2) in this said photoresist layer by photolithography.

4. A process according to claim 1 or claim 2, **characterized in that** the step (a) of producing the one or two patterns (2) comprises a step of direct etching in the bottom layer (1), said one or two patterns (2) then corresponding to one or more unetched parts of said bottom layer (1).

5. A process according to any one of claims 1 to 4, **characterized in that** the one or two patterns (2) have a height (H) of between 1 and 30 $\mu$m so as to create, in place of said pattern (2) or between said two patterns (2), a channel (4, 4a, 4b, 4c, 4d) having a height (H) of between 1 and 30 $\mu$m.

6. A process according to any one of claims 1 to 5,
   **characterized in that** the pattern (2) has a width (L) of between 5 and 1000 $\mu$m, preferably between 100 and 1000 $\mu$m, so as to create, in place of said pattern (2), a channel (4, 4a) having a width (L) of between 5 and 1000 $\mu$m, preferably between 100 and 1000 $\mu$m.

7. A process according to any one of claims 1 to 5, which includes a step (a) of producing two patterns (2) on the surface of the bottom layer (1), the process being **characterized in that** said two patterns (2) are spaced apart by a distance (L) not exceeding 5 $\mu$m, preferably not exceeding 4 $\mu$m, so as to create, between said two patterns (2), a channel (4, 4b, 4c, 4d) having a width (L) not exceeding 5 $\mu$m, preferably not exceeding 4 $\mu$m.

8. A process for fabricating at least two microchannels (4, 4a, 4b, 4c, 4d), closed over at least part of their length, on a substrate, especially for the purpose of creating a microstructured substrate, the process being **characterized in that** it includes a step of creating a first channel (4, 4a) by the process according to claim 6 and a step of creating a second channel (4, 4b, 4c, 4d) by the process according to claim 7.

9. A process according to claim 8, **characterized in that** it comprises a single step (b) of depositing a layer (3) of polymer material on top of both the bottom layer (1) and the patterns (2).

10. A substrate, especially of the microstructured type, intended for example for forming all or part of a microelectronic and/or microfluidic and/or micromechanical system, the substrate being **characterized in that** it comprises at least one channel (4, 4a, 4b, 4c, 4d) fabricated by the process according to any one of claims 1 to 7 and/or at least two channels (4, 4a, 4b, 4c, 4d) fabricated by the process according to claim 8 or claim 9, at least one channel of which has walls formed by a bottom layer (1), a layer (3) of polymer material and said two patterns (2) or a bottom layer (1) and a layer (3) of polymer material.

## Patentansprüche

1. Verfahren zur Herstellung wenigstens eines über wenigstens einen Teil seiner Länge geschlossenen Mikrokanals (4, 4a, 4b, 4c, 4d) auf einem Substrat, insbesondere um ein Substrat mikrostrukturierten Typs zu bilden, umfassend einen Schritt (a) zur Ausbildung von wenigstens einem oder von wenigstens zwei Mustern (2) auf der Oberfläche einer unteren Schicht (1), einen Schritt (b) zum Abscheiden einer Schicht (3) aus Polymermaterial über der unteren Schicht (1) und dem oder den beiden Mustern (2), **dadurch gekennzeichnet, daß** der Schritt (b) zum Abscheiden der Schicht (3) aus Polymermaterial einen Polymerisationsschritt in einem Reaktor (5) zur plasmaunterstützten chemischen Gasphasenabscheidung, eventuell Remote plasma-enhanced CVD, eines organischen oder metallorganischen Monomers mit Siloxan-Funktionen, vorzugsweise Tetramethyldisiloxan, umfaßt, um anstelle des Musters (2) und nach einem Entwicklungsschritt (c) durch Zersetzen dieses Musters (2), oder zwischen den beiden Mustern (2) ohne Entwicklungsschritt (c) durch Zersetzen dieser beiden Muster (2), einen über wenigstens einen Teil seiner Länge geschlossenen Kanal (4, 4a, 4b, 4c, 4d) zu bilden.

2. Verfahren nach Anspruch 1, **dadurch gekennzeichnet, daß** das während des Schrittes (b) zum Abscheiden der Schicht (3) aus Polymermaterial verwendete Monomer Siloxan-Funktionen, die frei von labilem Wasserstoff sind, vorzugsweise Hexamethyldisiloxan umfaßt.

3. Verfahren nach einem der Ansprüche 1 und 2, **dadurch gekennzeichnet, daß** der Schritt (a) zur Ausbildung des oder der beiden Muster (2) einen Schritt zum Abscheiden einer Photoresistschicht, beispielsweise mittels Schleuder oder durch Plasmapolymerisation, auf der unteren Schicht (1), sowie einen Schritt zur Ausbildung des oder der beiden Muster (2) in dieser Photoresistschicht durch Photolithographie umfaßt.

4. Verfahren nach einem der Ansprüche 1 und 2, **dadurch gekennzeichnet, daß** der Schritt (a) zur Ausbildung des oder der beiden Muster (2) einen Ätzschritt direkt in der unteren Schicht (1) umfaßt, wobei das oder die beiden Muster (2) dann einem nicht geätzten Teil oder nicht geätzten Teilen der unteren Schicht (1) entsprechen.

5. Verfahren nach einem der Ansprüche 1 bis 4, **dadurch gekennzeichnet, daß** das oder die beiden Muster (2) eine Höhe (H) im Bereich zwischen 1 und 30 μm aufweisen, um anstelle des Musters (2) oder zwischen den beiden Mustern (2) einen Kanal (4, 4a, 4b, 4c, 4d) mit einer Höhe (H) im Bereich zwischen 1 und 30 μm zu bilden.

6. Verfahren nach einem der Ansprüche 1 bis 5, **dadurch gekennzeichnet, daß** das Muster (2) eine Breite (L) im Bereich zwischen 5 und 1000 μm, vorzugsweise zwischen 100 und 1000 μm aufweist, um anstelle des Musters (2) einen Kanal (4, 4a) mit einer Breite (L) im Bereich zwischen 5 und 1000 μm, vorzugsweise zwischen 100 und 1000 μm zu bilden.

7. Verfahren nach einem der Ansprüche 1 bis 5, umfassend einen Schritt (a) zur Ausbildung von zwei Mustern (2) auf der Oberfläche der unteren Schicht (1), **dadurch gekennzeichnet, daß** die beiden Muster (2) um einen Abstand (L) kleiner oder gleich 5 μm, vorzugsweise kleiner oder gleich 4 μm voneinander beabstandet sind, um zwischen den beiden Mustern (2) einen Kanal (4, 4b, 4c, 4d) mit einer Breite (L) kleiner oder gleich 5 μm, vorzugsweise kleiner oder gleich 4 μm zu bilden.

8. Verfahren zur Herstellung von wenigstens zwei über wenigstens einen Teil ihrer Länge geschlossenen Mikrokanälen (4, 4a, 4b, 4c, 4d) auf einem Substrat, insbesondere um ein Substrat mikrostrukturierten Typs zu bilden, **dadurch gekennzeichnet, daß** es einen Schritt zur Bildung eines ersten Kanals (4, 4a) mittels des Verfahrens nach Anspruch 6 sowie einen Schritt zur Bildung eines zweiten Kanals (4, 4b, 4c, 4d) mittels des Verfahrens nach Anspruch 7 umfaßt.

9. Verfahren nach Anspruch 8, **dadurch gekennzeichnet, daß** es einen einzigen Schritt (b) zum Abscheiden einer Schicht (3) aus Polymermaterial über der unteren Schicht (1) und den Mustern (2) umfaßt.

10. Substrat, insbesondere mikrostrukturierten Typs, das beispielsweise dazu bestimmt ist, ein ganzes mikroelektronisches und/oder mikrofluidisches und/oder mikromechanisches System oder einen Teil hiervon zu bilden, **dadurch gekennzeichnet, daß** es wenigstens einen mittels des Verfahrens nach einem der Ansprüche 1 bis 7 hergestellten Kanal (4, 4a, 4b, 4c, 4d) und/oder wenigstens zwei mittels des Verfahrens nach einem der Ansprüche 8 und 9 hergestellte Kanäle (4, 4a, 4b, 4c, 4d) umfaßt, von denen wenigstens ein Kanal Wände aufweist, die durch eine untere Schicht (1), eine Schicht (3) aus Polymermaterial und die beiden Muster (2) oder eine untere Schicht (1) und eine Schicht (3) aus Polymermaterial gebildet sind.

FIG.1

FIG.2

FIG.3A

FIG.3B

FIG.3C

FIG.4

FIG.5

**EP 2 401 224 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2002025529 A1

**Littérature non-brevet citée dans la description**

- **KOHL P A ; ZHAO Q ; PATEL K ; SCHMIDT D ; ALLEN S A B ; SHICK R ; JAYARAMAN S.** Air-Gaps for Electrical Interconnections Electrochem. *Solid-State Lett.,* 1998, vol. 1, 49-51
- **ZHAO B ; MOORE J S ; BEEBE D J.** Surface-Directed Liquid Flow Inside Microchannels. *Science,* 2001, vol. 291, 1023-26
- **DELAMARCHE E ; BERNARD A ; SCHMID H ; MICHEL B ; BIEBUYCK H.** Patterned 1997 Delivery of Immunoglobulins to Surfaces Using Microfluidic Networks. *Science,* 1997, vol. 276, 779-781
- **TREIZEBRÉ A ; BOCQUET B.** Nanometric metal wire as a guide for THz investigation of living cells. *Int. J. Nanotechnol.,* 2008, vol. 05 (6/7/8), 784-95
- **BOER M J D ; TJERKSTRA R W ; BERENSCHOT J W ; JANSEN H V ; BURGER G J ; GARDENIERS J G E ; ELWENSPOEK M ; VAN DEN BERG A.** Micromachining of Buried Micro Channels in Silicon. *IEEE J. MEMS,* 2000, vol. 9, 94-103
- **DWIVEDI V K ; GOPAL R ; AHMAD S.** Fabrication of very smooth walls and bottoms of silicon microchannels for heat dissipation of semiconductor devices. *Microelectron. J.,* 2000, vol. 31, 405-410
- **MCDONALD J C ; WHITESIDES G M.** Poly(dimethylsiloxane) as a material for fabricating microfluidic devices. *Acc. Chem. Res.,* 2002, vol. 35, 491-499
- **CHIE R-D.** Micromolding of biochip devices designed with microchannels Sens. *Actuators, A: Physical,* 2006, vol. 128, 238-247
- **PEENI B A ; LEE M L ; HAWKINS A R ; WOOLLEY A T.** Sacrificial layer microfluidic device fabrication methods. *Electrophoresis,* 2006, vol. 27, 4888-4895
- **CHATTERJEE R ; FAYOLLE M ; LEDUC P ; POZDER S ; JONES B ; ACOSTA E ; CHARLET B ; ENOT T ; HEITZMANN M ; ZUSSY M.** Three dimensional chip stacking using a wafer-to-wafer intégration. *International Interconnect Technology Conference,* 04 Juin 2007, 81-83

- **WALSH K ; ORVILLE J ; TAI Y-C.** Photoresist as a sacrificial layer by dissolution in acetone. *The 14th IEEE International Conférence on Micro Electro Mechanical Systems,* 2001, 114-117
- **JAYACHANDRAN J P ; REED H A ; ZHEN H ; RHODES L F ; HENDERSON C L ; ALLEN S A B ; KOHL P A.** Air-Channel Fabrication for Microelectromechanical Systems via Sacrificial. *Photosensitive Polycarbonates IEEE J. MEMS,* 2003, vol. 12, 147-159
- **L S AND GLEASON K K.** Hot filament chemical vapor deposition of polyoxymethylene as a sacrificial layer for fabricating air gaps Electrochem. *Solid-State Lett.,* 2001, vol. 4, G81-G84
- **BHUSARI D ; REED H A ; WEDLAKE M ; PADOVANI A M ; SUE ANN BIDSTRUP ALLEN ; KOHL P A.** Fabrication of air-channel structures for microfluidic, microelectromechanical, and microelectronic applications. *IEEE J. MEMS,* 2001, vol. 10, 400-408
- **WU X ; REED H A ; WANG Y ; RHODES L F ; ELCE E ; RAVIKIRAN R ; SHICK R A ; HENDERSON C L ; ALLEN S A B ; KOHL P A.** Fabrication of Microchannels Using Polynorbornene Photosensitive Sacrificial Materials. *J. Electrochem. Soc.,* 2003, vol. 150, H205-H213
- **NOHA H-S ; CHOIB Y ; WU C-F ; HESKETHAAND P J ; ALLEN M G.** Rapid, low-cost fabrication of parylene microchannels for microfluidic applications. *The 12th International Conference on Solid State Sensors, Actuators and Microsystems: Boston,* 08 Juin 2003
- **LINDER V ; GATES B D ; RYAN D ; PARVIZ B A ; WHITESIDES G M.** Water-Soluble Sacrificial Layers for Surface. *Micromachining Small,* 2005, vol. 7, 730-6